Europäisches Patentamt

European Patent Office

Office européen des brevets

(11) Publication number: 0 324 439
A2

# EUROPEAN PATENT APPLICATION

(21) Application number: 89100351.9

(51) Int. Cl.4: H01H 50/14 , H05K 5/00

(22) Date of filing: 10.01.89

(30) Priority: 13.01.88 JP 3330/88 U
13.01.88 JP 3331/88 U

(43) Date of publication of application:
19.07.89 Bulletin 89/29

(84) Designated Contracting States:
AT BE CH DE ES FR GB GR IT LI LU NL SE

(71) Applicant: OMRON TATEISI ELECTRONICS
CO.
10, Tsuchido-cho Hanazono Ukyo-ku
Kyoto-shi Kyoto-fu(JP)

(72) Inventor: Sagawa, Hiroyuki
c/o Omron Tateisi Electronics Co. 20,
Igadera
Shimokaiinji Nagaokakyo shi Kyoto-fu(JP)

(74) Representative: WILHELMS, KILIAN &
PARTNER Patentanwälte
Eduard-Schmid-Strasse 2
D-8000 München 90(DE)

(54) Package for an electromagnetic relay.

(57) A package for a surface mount type electromagnetic relay, comprising an inner casing for accommodating an electromagnetic relay main body therein; and an outer casing accommodating said inner casing therein in a mutually spaced relationship. Optionally, the space may be filled with heat insulating solid or liquid, or with a bonding agent. Because of the presence of the space between the inner and outer casings, the electromagnetic relay main body is protected from the heat when the electromagnetic relay is being mounted on the surface of a circuit board. Since the inner casing may consist of a normal package for an electromagnetic relay for general purpose, the electromagnetic relay main body as packaged in the inner casing may be used either as a surface mount type electromagnetic relay by using an outer casing therewith or as a normal electromagnetic relay without using any outer casing with the result that the manufacturing and stocking of electromagnetic relays for different applications may be simplified.

FIG. 2

## PACKAGE FOR AN ELECTROMAGNETIC RELAY

TECHNICAL FIELD

The present invention generally relates to a surface mount type electromagnetic relay which is suitable to be mounted on the surface of a circuit board, and in particular to a package for such an electromagnetic relay which is equipped with a favorable heat insulating structure.

BACKGROUND OF THE INVENTION

A typical surface mount type electromagnetic relay comprises a base supporting an electromagnetic relay main body, a plurality of terminal leads led out from the electromagnetic relay main body and passed through the base, and a cover which is fitted upon the base so as to enclose the electromagnetic relay main body within the space defined between the base and the cover. Since a surface mount type electromagnetic relay is subjected to a considerable amount of heat during the mounting process, the cover as well as the base is required to have a large thickness so as to withstand the adverse influences from the heat upon the electromagnetic relay main body. Therefore, a surface mount type electromagnetic relay is required to be manufactured as such and is substantially more costly than a normal electromagnetic relay for general purpose because of the difference in packaging. Furthermore, the need for stocking two types of electromagnetic relays is disadvantageous.

BRIEF SUMMARY OF THE INVENTION

In view of such problems of the prior art, a primary object of the present invention is to provide a package for electromagnetic relay which allows each electromagnetic relay main body to be utilized either as a normal electromagnetic relay or as a surface mount type electromagnetic relay as required.

A second object of the present invention is to provide a package for a surface mount type electromagnetic relay which has improved capability to insulate the electromagnetic relay main body from heat.

A third object of the present invention is to provide a package for a surface mount type electromagnetic relay which can reduce the level of noises emitted from the electromagnetic relay as it operates.

These and other objects of the present invention can be accomplished by providing: a package for a surface mount type electromagnetic relay, comprising an inner casing for accommodating an electromagnetic relay main body therein; and an outer casing accommodating said inner casing therein in a mutually spaced relationship. Such a space can be conveniently produced by providing a plurality of projections provided in the inner surface of said outer casing so as to abut the outer surface of the inner casing.

Deformation of the electromagnetic relay main body due to thermal stress can be avoided without increasing the thickness of the inner casing. Therefore, the electromagnetic relay as packaged in the inner casing may be used either as an electromagnetic relay for mounting on the surface of a circuit board with an outer casing or as a normal electromagnetic relay for general purpose without any outer casing. The heat insulation effect produced by the space of the double casing structure prevents the properties of the electromagnetic relay from being affected by the changes in the ambient temperature.

According to a preferred embodiment of the present invention, said outer casing comprises a base part through which terminals leads are passed and a cover part which is fitted upon said base part. Particularly favorable physical and thermal properties can be obtained if the space defined between said inner and outer casings is substantially filled with a bonding agent. In this case, said outer casing may consist of a simple open bottom box.

To the end of preventing excessive stress to be produced in the solidified solder for connecting the terminal leads to the circuit pattern of the circuit board which may be caused by the residual stress which may be present in the terminal leads, according to a certain preferred embodiment of the present invention, the terminal leads of said electromagnetic relay main body are passed through the part of said inner casing remote from the open bottom of said outer casing, extend along a part of said space defined between an outer side surface of said inner casing and an inner side surface of said outer casing, and are led out of said open bottom of said outer casing. Thus increasing the lengths of the terminal leads also contributes to the reduction of heat conduction to the electromagnetic relay main body through the terminal leads.

BRIEF DESCRIPTION OF THE DRAWINGS

Now the present invention is described in the following in terms of specific embodiments with reference to the appended drawings, in which:

Figure 1 is a perspective view of a first embodiment of the package for the surface mount type electromagnetic relay according to the present invention;

Figure 2 is a sectional view of the same;

Figure 3 is a perspective view similar to Figure 1 showing a second embodiment of the present invention;

Figure 4 is a sectional view similar to Figure 2, showing the second embodiment of the present invention; and

Figure 5 is a sectional view taken along line V-V of Figure 4.

## DESCRIPTION OF THE PREFERRED EMBODIMENTS

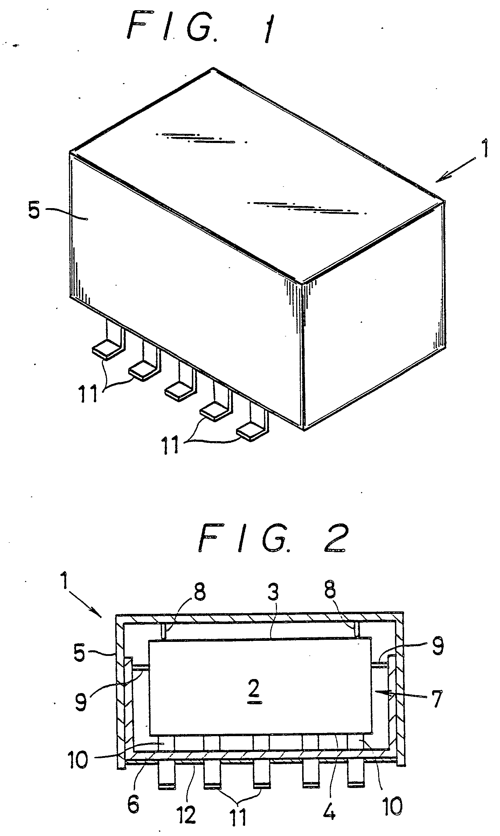

Referring to Figures 1 and 2, the first embodiment of the electromagnetic relay 1 according to the present invention comprises an inner casing 2 which consists of a cover 3 and a base 4 and encloses an electromagnetic relay main body not shown in the drawings therein, and the electromagnetic relay in this package consisting of the cover 3 and the base 4 can also be used as an ordinary electromagnetic relay for general purpose.

The inner casing 2 is further enclosed by an external cover 5 and an external base 6. The external cover 5 and the external base 6 are joined together by one of them receiving the other, and seal off the inner casing 2 from outside. A space 7 is defined between the inner casing 2 and the external cover and base 5 and 6 with a plurality of projections 8 and 9 projecting from appropriate parts of the external cover 5 and the external base 6 abutting the outer surface of the inner casing 2. The projections 8 and 9 keep the inner casing 2 immobile within the space 7.

A plurality of terminal leads 10 projecting from the base 4 of the inner casing 2 are connected to corresponding terminal leads 11 which are passed through the external base 6 by insert molding. Numeral 12 denotes a layer of a bonding agent for attaching the electromagnetic relay 1 to the surface of a circuit board. Alternatively, the external base 6 may be provided with a plurality of holes for passing therethrough the terminal leads 10 projecting from the inner casing 2. The gap which may be defined around the terminal leads may be filled with a suitable sealing agent.

In a surface mount type electromagnetic relay 1 of this structure, the external cover 5 and the external base 6 are subjected to heat when mounting the electromagnetic relay 1 on the surface of a circuit board, but this heat is transmitted to the electromagnetic relay main body inside the inner casing 2 which is floated from both the external cover 5 and the external base 6, via the space 7. Because the space 7 effectively insulates heat and delays transmission of heat, the thermal stress to which the electromagnetic relay main body is subjected is reduced and deformation is avoided from being caused therein.

Additionally, since the presence of the space 7 protects the electromagnetic relay main body 2 from the changes in the temperature of the environment in which the electromagnetic relay 1 is being used, not only the influences of temperature changes on the electromagnetic relay main body can be reduced but also the sound produced by the action of the electromagnetic relay main body is avoided from being transmitted to the outside as a noise.

In this way, because the thickness of the internal cover and base structure is not increased as opposed to conventional surface mount type electromagnetic relays owing to the double casing structure and the presence of the space 7 therebetween, the electromagnetic relay main body as packaged in the inner case 2 can be used either as an ordinary electromagnetic relay for general purpose as it is or as a surface mount type electromagnetic relay protected by such an external cover and base, and the manufacturing cost can be significantly reduced.

A further enhanced effect will be produced if the space 7 is filled with a liquid or solid substance having heat absorbing property.

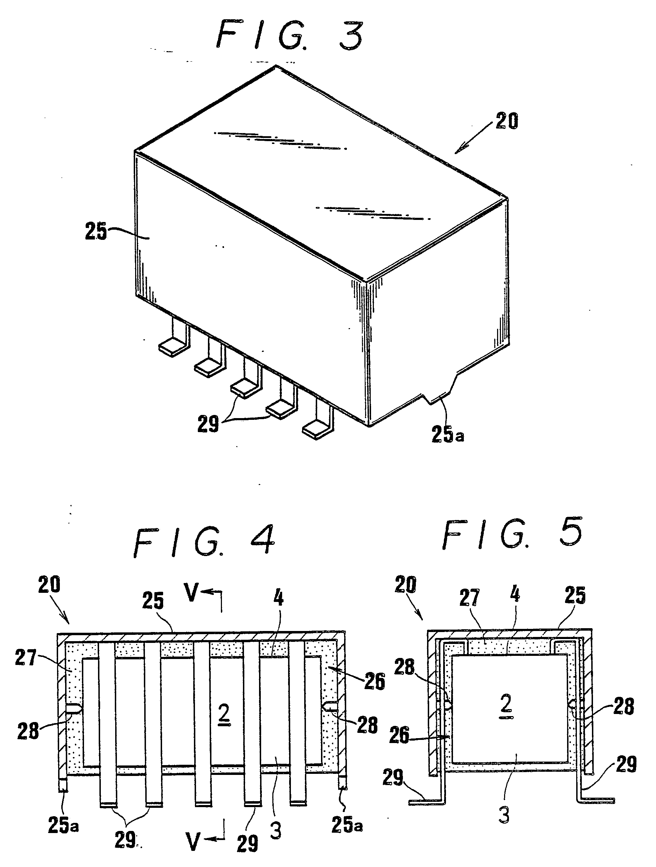

Figures 3 though 5 show the second embodiment of the present invention. In this embodiment also, the electromagnetic relay main body packaged in an inner casing 2 consisting of a cover 3 and a base 4 can be used as an ordinary electromagnetic relay for general purpose, but it is further received in a separately manufactured outer casing 25, consisting of an open bottom box, with the base 4 of the inner casing 2 directed inwardly. The central parts of the bottom edge of the two longitudinal end walls of the casing 25 are provided with projections 25a for securing the electromagnetic relay 20 by being fitting into corresponding openings provided in the circuit board. The inner casing 2 is kept spaced from the inner surface of the outer casing 25 by a plurality of projections 28 projecting from the inner surface of the outer casing 25 and abutting the outer surface of the inner casing 2. The space 26 thus defined between the inner casing 2 and the outer casing 25 is filled with a bonding agent 27, and the inner casing 2 and the outer casing 25 are thereby combined into a solid integral body.

Terminals 29 of the electromagnetic relay main body passed through the base 4 of the inner casing 2 are led out of the upper part of the inner casing 2, and are passed downwardly through the space 26 between the side walls of the inner casing 2 and the outer casing 25 until they are exposed to the exterior of the outer casing 25 at its open bottom end.

According to this embodiment also, the outer casing 25 is subjected to a high temperature when mounting the electromagnetic relay 20 on the surface of a circuit board, but this heat is first transmitted to the external cover 25 and is dissipated as it is first transmitted through the external cover 25 and the bonding agent 27 whereby the thermal stress acting upon the electromagnetic relay main body is reduced, and an ordinary electromagnetic relay for general purpose may be safely used without producing any thermal deformations. Therefore, the design and manufacturing work of the surface mount type electromagnetic relay is not in any way specialized, and the manufacturing cost can be thereby reduced.

Additionally, since the presence of the outer casing 25 and the bonding agent 27 protects the electromagnetic relay main body from the changes in the temperature of the environment, the influences of temperature changes on the electromagnetic relay main body are reduced.

By passing the terminal leads 29 of the electromagnetic relay main body through the interior of the external cover 25 and by thus increasing the lengths of the terminal leads 29, the terminal leads are made so compliant that solder cracks are avoided from occurring when soldering these terminal leads to the circuit patterns of the circuit board.

By selecting a bonding agent having a high toughness and a favorable heat resistance, the deterioration of the bonding agent when mounting the electromagnetic relay on the surface of a circuit board can be prevented.

## Claims

1. A package for a surface mount type electromagnetic relay, comprising an inner casing for accommodating an electromagnetic relay main body therein; and
an outer casing accommodating said inner casing therein in a mutually spaced relationship.

2. A package as defined in claim 1, wherein a plurality of projections are provided in the inner surface of said outer casing to keep said inner and outer casings in said mutually spaced relationship.

3. A package as defined in claim 2, wherein said outer casing comprises a base part through which terminals leads are passed and a cover part which is fitted upon said base part.

4. A package as defined in claim 2, wherein the space defined between said inner and outer casings is substantially filled with liquid or solid substance.

5. A package as defined in claim 2, wherein the space defined between said inner and outer casings is substantially filled with a bonding agent.

6. A package as defined in claim 5, wherein said outer casing consists of an open bottom box.

7. A package as defined in claim 6, wherein the terminal leads of said electromagnetic relay main body are passed through the part of said inner casing remote from the open bottom of said outer casing, extend along a part of said space defined between an outer side surface of said inner casing and an inner side surface of said outer casing, and are led out of said open bottom of said outer casing.

# FIG. 1

# FIG. 2

EP 0 324 439 A2

# F I G. 3

25
20
29
25a

# F I G. 4

20
25
V
4
27
26
28
2
28
25a
29
V
29
3
25a

# F I G. 5

20
27
4
25
28
28
26
2
29
3
29